# EUROPEAN PATENT APPLICATION

(11) **EP 1 416 536 A2**
(43) Date of publication of application: **06.05.2004**
(21) Application number: 03104026.4
(22) Date of filing: 30.10.2003
(51) Int. Cl.: H01L 23/525

(54) **Eliminating defective decoupling capacitors**

(30) Priority: 04.11.2002 US 287403
(71) Applicant: TEXAS INSTRUMENTS INCORPORATED, Dallas, TX 75265 (US)
(72) Inventor: Pitts, Robert L., 75048, Dallas (US)
(74) Representative: Holt, Michael

(57) **Abstract**

An embodiment of the invention is circuitry that contains a fuse 9 connected between a decoupling capacitor 4 and a power rail 11. Another embodiment of the invention is a method of eliminating defective decoupling capacitors 4 by applying power to a power rail 10 to blow a fuse 9 that is connected to a defective decoupling capacitor 4.

## Description

### FIELD OF THE INVENTION

This invention relates to the elimination of shorted decoupling capacitors.

### SUMMARY OF THE INVENTION

According to a first aspect of the invention, there is provided a circuit comprising at least one decoupling capacitor coupled between a first power rail and a second power rail; and at least one fuse coupled between said at least one decoupling capacitor and at least one said power rail. According to a second aspect of the invention, there is provided a method for eliminating defective capacitors comprising applying power to a circuit wherein a fuse connected to a shortened decoupling capacitor blows open.

### BRIEF DESCRIPTION OF THE DRAWINGS

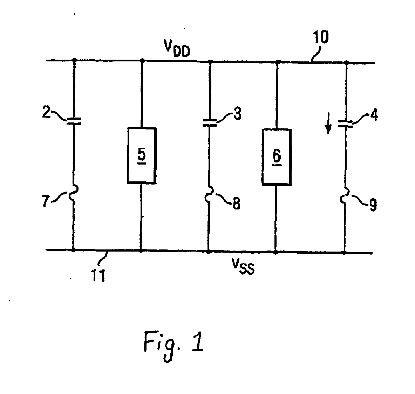

Figure 1 shows a circuit for eliminating defective decoupling capacitors in accordance with the invention.

### DETAILED DESCRIPTION OF THE INVENTION

A defective decoupling capacitor may cause a circuit's power supply to short to ground. This invention is a circuit and method for eliminating defective decoupling capacitors. Several aspects of the invention are described below with reference to example applications for illustration. It should be understood that numerous specific details, relationships, and methods are set forth to provide a full understanding of the invention. One skilled in the relevant art, however, will readily recognize that the invention can be practiced without one or more of the specific details or with other methods. In other instances, well-known structures or operations are not shown in detail to avoid obscuring the invention.

Referring to Figure 1, decoupling capacitors 2, 3, 4 are coupled between two power rails 10, 11. These decoupling capacitors 2, 3, 4 protect the logic circuitry 5, 6 from transient voltage spikes and stabilize the supply voltage that is seen by the logic circuitry 5, 6. In the preferred embodiment, power rail 10 is V_{dd} or V_{cc}. Also in the preferred embodiment, power rail 11 is Vₛₛ or ground.

Decoupling capacitors 2, 3, 4 may be a single capacitor; however, in the preferred embodiment they are an array of decoupling capacitors connected in parallel. Also in the preferred embodiment, the decoupling capacitors are made from a high-k dielectric film such as Ta₂O₅; however, capacitors made from other materials such as gate oxide, metal plate capacitors, or metal flux capacitors are also within the scope of this invention.

Referring again to Figure 1, there are fuses 7, 8, 9 that are coupled between power rail 11 and decoupling capacitors 2, 3, and 4 respectively. In the preferred embodiment, fuses 7, 8, 9 are poly electrical fuses having a resistance of approximately 100Ω. However, it is within the scope of this invention to use alternative fuses such as contact, via, or metal fuses. Moreover, it is within the scope of this invention to use fuses having a different resistance, for example a fuse having a nominal resistance anywhere from 10Ω to 300Ω. In the preferred embodiment the resistance of the fuses 7, 8, 9 is kept to a minimal level in order to allow the non-defective decoupling capacitors to efficiently mitigate the effects of high frequency current glitches on the power rail 10.

When power is applied to the circuit on power rail 10 the non-defective decoupling capacitors will function in a manner that will support the logic circuitry 5, 6. However, if any decoupling capacitor has a shorting defect, for example in one or more of the capacitors in the capacitor array 4, then the defective decoupling capacitor may be very low resistance and act as a short that allows excessive current (i.e. up to tens of milliamps, depending on the supply voltage) to flow into the electrical fuse 9 connected to the capacitor array 4. This excessive current will overwhelm the fuse 9 and cause the fuse 9 to blow (i.e. become high resistance); thereby creating an open circuit and removing the defective decoupling capacitor array 4 from further operation.

Alternatively, the fuse 9 connected to the shorted decoupling capacitor 4 can be blown by raising the voltage level on power rail 10 to a level that opens the circuit (i.e. 1.5 to 2 times the normal operating voltage). The increased voltage only has to be present on power rail 10 for a short time (i.e. 2-3 ps); therefore the voltage on rail 10 can be raised safely to any level below the reliability imposed voltage limit in order to open a circuit containing a defective decoupling capacitor.

Various modifications to the invention as described above are within the scope of the claimed invention. As an example, instead of the thin film decoupling capacitor described above, a transistor or other gate structure acting as a decoupling capacitor is within the scope of this invention. In addition, the functions comprehended by the invention could be accomplished in various technologies such as CMOS or TTL.

While various embodiments of the present invention have been described above, it should be understood that they have been presented by way of example only, and not limitation. Numerous changes to the disclosed embodiments can be made in accordance with the disclosure herein without departing from the scope of the invention. Thus, the breadth and scope of the present invention should not be limited by any of the above described embodiments. Rather, the scope of the invention should be defmed in accordance with the following claims and their equivalents.

## Claims

1. A circuit comprising:
at least one decoupling capacitor coupled between a first power rail and a second power rail; and
at least one fuse coupled between said at least one decoupling capacitor and at least one said power rail.

2. The circuit of Claim 1 wherein said decoupling capacitor is comprised of gate oxide.

3. The circuit of Claim 1 or 2 wherein one of said power rails is V_{dd} and the other one of said power rails is ground.

4. The circuit of any one of Claims 1 to 3 wherein said decoupling capacitor is comprised of high-k dielectric film.

5. The circuit of Claim 1 wherein said fuse is a poly electrical fuse.

6. A circuit comprising:
two or more parallel decoupling capacitors coupled between a first power rail and a second power rail; and
one fuse connected between said decoupling capacitors and said first power rail.

7. The circuit of Claim 6 wherein said fuse is a poly electrical fuse.

8. The circuit of Claim 6 or 7 wherein said fuse has a nominal resistance below approximately 200 ohms.

9. The circuit of any one of Claims 6 to 8 wherein said decoupling capacitors are comprised of gate oxide.

10. The circuit of any one of Claims 6 to 9 wherein said decoupling capacitors are comprised of high-k dielectric film.

11. The circuit of any one of Claims 6 to 10 wherein said first power rail is ground.

12. The circuit of any one of Claims 6 to 11 wherein said second power rail is V_{dd}.

13. A method for eliminating defective capacitors comprising:
applying power to a circuit wherein a fuse connected to a shortened decoupling capacitor blows open.

14. The method of claim 13 wherein said fuse is blown by current flowing from a power rail, through said shortened decoupling capacitor, and then into said fuse.

15. The method of claim 13 or 14 wherein the level of said power is approximately V_{dd}.

16. The method of claim 13 or 14 wherein the level is said power is between V_{dd} and the maximum reliability imposed voltage limits of said circuit.
